(19)

Europäisches Patentamt

European Patent Office

Office européen des brevets

(11) **EP 4 506 231 A1**

(12) **EUROPEAN PATENT APPLICATION**
published in accordance with Art. 153(4) EPC

(43) Date of publication:
**12.02.2025 Bulletin 2025/07**

(21) Application number: **22936454.2**

(22) Date of filing: **04.04.2022**

(51) International Patent Classification (IPC):
**B62D 1/06** $^{(2006.01)}$

(52) Cooperative Patent Classification (CPC):
**H03K 17/962; G01R 27/2605; G01R 31/2829;**
B62D 1/046; B62D 1/06; H03K 2217/960705

(86) International application number:
**PCT/JP2022/017065**

(87) International publication number:
**WO 2023/195052 (12.10.2023 Gazette 2023/41)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **NISSAN MOTOR CO., LTD.
Kanagawa 221-0023 (JP)**

(72) Inventor: **ISHIKAWA, Ken
Atsugi-shi, Kanagawa 243-0123 (JP)**

(74) Representative: **Osha BWB
2, rue de la Paix
75002 Paris (FR)**

(54) **CONTACT DETERMINATION METHOD AND CONTACT DETERMINATION DEVICE**

(57)     A contact determination method determines contact of a driver with a steering wheel based on an electric signal detected from a sheet-shaped electrode portion, the electrode portion being formed by laminating a first electrode and a second electrode with an insulator interposed between and being provided to cover an outer peripheral portion of the steering wheel. The contact determination method includes a detection step of detecting a capacitance and an impedance generated in the electrode portion, and a determination step of determining, based on the capacitance and the impedance detected in the detection step, whether a hand of a driver is in contact with the steering wheel and whether the electrode portion is abnormal. In the determination step, the electrode portion is determined to be abnormal when the capacitance exceeds a first threshold and the impedance is less than a second threshold.

Fig.5

**Description**

TECHNICAL FIELD

The present invention relates to a contact determination method and a contact determination device for determining contact of a driver with a steering wheel.

BACKGROUND ART

WO2021/095478 discloses a technique in which two electrodes are provided on an outer peripheral portion of a steering wheel via an insulator to overlap each other, and contact of a driver with the steering wheel is determined.

SUMMARY OF INVENTION

Generally, a steering wheel has a complicated surface rather than a flat surface. Therefore, when a sheet-shaped electrode and an insulator are attached to the steering wheel, it is necessary to attach the sheet-shaped electrode and the insulator by using a jig or the like in accordance with a complicated surface of the steering wheel. However, when there is a failure in the electrode or the electrode is damaged at the time of the attachment operation, a part of the electrode may be cut. In such a state, the electrode becomes abnormal, and it is impossible to perform appropriate contact determination.

An object of the present invention is to more reliably determine an abnormal state of an electrode portion in a case of determining contact of a driver with a steering wheel.

An aspect of the present invention relates to a contact determination method for determining contact of a driver with a steering wheel based on an electric signal detected from a sheet-shaped electrode portion, the electrode portion being formed by laminating a first electrode and a second electrode with an insulator interposed therebetween and being provided to cover an outer peripheral portion of the steering wheel. The contact determination method includes a detection step of detecting a capacitance and an impedance generated in the electrode portion, and a determination step of determining, based on the capacitance and the impedance detected in the detection step, whether a hand of the driver is in contact with the steering wheel and whether the electrode portion is abnormal. In the determination step, it is determined that the electrode portion is abnormal when the capacitance exceeds a first threshold and the impedance is less than a second threshold.

BRIEF DESCRIPTION OF DRAWINGS

[FIG. 1] FIG. 1 is a diagram illustrating a simplified configuration example of a contact determination device.
[FIG. 2] FIG. 2 is a diagram illustrating an example of a case where a part of a second electrode is cut.
[FIG. 3] FIG. 3 is a diagram illustrating a contact determination example as a comparative example.
[FIG. 4] FIG. 4 is a diagram illustrating an example of determination processing of performing a contact determination based on a capacitance and an impedance generated in an electrode portion.
[FIG. 5] FIG. 5 is a flowchart illustrating an example of contact determination processing in the contact determination device.

DESCRIPTION OF EMBODIMENTS

Hereinafter, an embodiment of the present invention will be described with reference to the accompanying drawings.

[Configuration Example of Contact Determination Device]

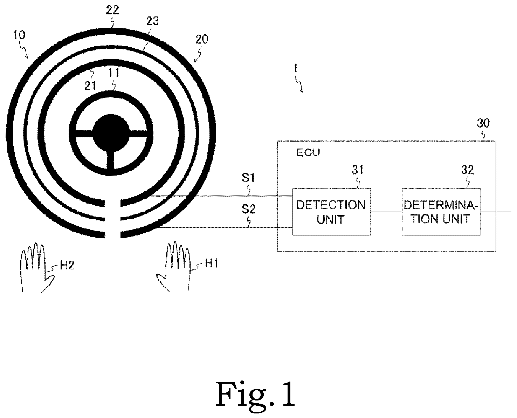

FIG. 1 is a diagram illustrating a simplified configuration example of a contact determination device 1. The contact determination device 1 is a device installed in a vehicle, and is a device that determines whether hands H1 and H2 of a driver of the vehicle are in contact with a steering wheel 10. The steering wheel 10 is installed in front of a seat (driver seat) on which a driver sits.

The contact determination device 1 includes a sheet-shaped electrode portion 20 provided on the steering wheel 10, and an electronic control unit (ECU) 30. The electrode portion 20 functions as a so-called touch sensor, and is a sheet-shaped electrode portion formed by laminating a first electrode 21 and a second electrode 22 with an insulator 23 interposed therebetween. The first electrode 21 may also be referred to as an active shield electrode, and the second electrode 22 may also be referred to as a sensor electrode. The touch sensor implemented by the electrode portion 20 is, for example, a capacitance type touch sensor.

Here, the steering wheel 10 is an operation member including a core metal 11 that forms a framework of the steering wheel 10 and is formed of metal material, and is used when a driver who drives the vehicle steers the vehicle. A substantially circular ring-shaped gripping portion of the steering wheel 10 is a portion gripped by the hands of the driver who drives the vehicle, and the periphery of the core metal 11 is covered by a substrate. An insulating material is used as the substrate. For example, a resin material such as urethane is used as the substrate.

The first electrode 21 is a sheet-shaped electrode electrically connected to the ECU 30 via a signal line S1. The second electrode 22 is a sheet-shaped electrode electrically connected to the ECU 30 via a signal line S2. The insulator 23 is an elastic sheet-shaped insulator, for example, an insulating sheet.

The electrode portion 20 is attached to an outer peripheral portion of the substrate constituting the gripping portion of the steering wheel 10 to cover the substrate in a circumferential direction of the steering wheel 10. The first electrode 21 is disposed on an inner peripheral side of the steering wheel 10, and the second electrode 22 is disposed on the outer peripheral side of the steering wheel 10. Although FIG. 1 illustrates an example in which the electrode portion 20 is provided in all portions of the steering wheel 10 in the circumferential direction, the electrode portion 20 may be provided in a part of the steering wheel 10 in the circumferential direction. On the outer peripheral portion of the electrode portion 20, an exterior portion is mounted as a contact portion which is a portion gripped by the hands of the driver. The exterior portion is preferably formed of insulating leather or resin. In this way, the electrode portion 20 is disposed between the substrate and the exterior portion in the gripping portion of the steering wheel 10. That is, the electrode portion 20 is covered by the exterior portion.

The ECU 30 controls each unit based on various programs stored in a storage unit (not illustrated), and includes a detection unit 31 and a determination unit 32. The ECU 30 is implemented by a processing device such as a central processing unit (CPU). The storage unit stores various types of information (for example, control programs and detection values) necessary for the ECU 30 to perform various types of processing. As the storage unit, for example, a read only memory (ROM), a random access memory (RAM), a hard disk drive (HDD), a solid state drive (SSD), or a combination thereof may be used.

The detection unit 31 is connected to the first electrode 21 via the signal line S1, is connected to the second electrode 22 via the signal line S2, detects a capacitance and an impedance generated in the first electrode 21 and the second electrode 22, and outputs the detection result to the determination unit 32. For example, the detection unit 31 supplies an alternating current signal to the electrode portion 20, and detects the capacitance and the impedance generated in the first electrode 21 and the second electrode 22 based on a response signal acquired in response to the alternating current signal. A well-known measurement method can be used as a method for measuring the capacitance and the impedance. For example, the impedance can be detected based on a ratio (current/voltage) of signals acquired from measurement results obtained by applying the alternating current signal to the electrode portion 20 and simultaneously measuring the voltage and the current. For example, an absolute self-capacitance type electrostatic IC capable of simultaneously measuring sensor inputs of a plurality of zones and having a characteristic that a drive waveform of a sensor is a sine wave can be adopted as the detection unit 31. The electrostatic IC drives a shield electrode (first electrode 21), and compares a drive waveform thereof with an input waveform from a sensor electrode (second electrode 22). The electrostatic IC performs digital conversion on a difference waveform obtained by the comparison, and demodulates and integrates the difference waveform subjected to the digital conversion with a sin component and a cos component of a drive frequency to calculate detection values. Among the detection values, the impedance is calculated based on the calculation result of the sin component, and the capacitance is calculated based on the calculation result of the cos component. In this way, the detection unit 31 can output a sine wave to the electrode portion 20 and detect the capacitance and the impedance based on a difference in phase and amplitude between the sine wave and a response wave.

In addition, for example, when the hands of the driver come into contact with or approach the steering wheel 10, the hands of the driver approach the second electrode 22, and a capacitance Crg of the second electrode 22 changes. The capacitance Crg of the second electrode 22 can be detected by a capacitance method such as a self-capacitance method or a mutual capacitance method. That is, the detection unit 31 can detect the capacitance generated in the second electrode 22 according to the contact of the driver with the steering wheel 10 by the capacitance method such as a self-capacitance method or a mutual capacitance method.

[Example of Occurrence of Problem in Electrode Portion]

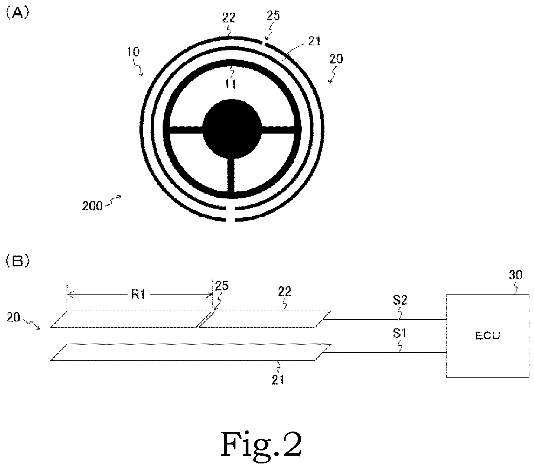

FIG. 2 is a diagram illustrating an example in which a part of the second electrode 22 is cut. In (A) of FIG. 2, a position 25 where a part of the second electrode 22 is cut in the steering wheel 10 is illustrated in a simplified manner. In (A) of FIG. 2, a part of the configuration of the contact determination device 1 illustrated in FIG. 1 is omitted. In addition, (B) of FIG. 2 schematically illustrates a relationship among the first electrode 21, the second electrode 22, and the ECU 30 for ease of description.

Here, a step of attaching the electrode portion 20 to the steering wheel 10 will be described. Here, an example is illustrated in which conductive cloth obtained by subjecting cloth woven in a mesh structure to a metal plating treatment is used as the sheet-shaped first electrode 21 and the sheet-shaped second electrode 22. The conductive cloth has flexibility and extensibility, but it is also assumed that the metal plating is peeled off or the mesh of the conductive cloth is easily widened.

For example, when the sheet-shaped electrode portion 20 is attached to the steering wheel 10, it is necessary to wind the sheet-shaped electrode portion 20 around the steering wheel 10 using a jig such as a perforating rod. However, since the steering wheel 10 has no flat surface, the sheet-shaped electrode portion 20 is wound around a complicated surface. At the time of the attachment operation, it is also assumed that the conductive cloth may be stretched, or the conductive cloth may be further damaged by an excessive pushing operation by the perforating rod while the conductive cloth is stretched. It is also assumed that an electrode of the conductive cloth has a problem such as a failure. In this way, in a case where there is a problem such as a failure in the electrode or the electrode is damaged at the time of the attachment operation, a part of the electrode is cut. In such a state, after a leather winding operation of winding the exterior portion around the sheet-shaped electrode portion 20 is performed, when the exterior portion is gripped by the driver, the conductive cloth may expand and contract, and the cut portion of the electrode may further expand. In this way, when the cut portion of the electrode further expands, a resistance value of the cut portion increases.

For example, as illustrated in (A) of FIG. 2, it is assumed that a part of the second electrode 22 is cut at the position 25 on the steering wheel 10. (B) of FIG. 2 schematically illustrates a case where the sheet-shaped first electrode 21 and the sheet-shaped second electrode 22 are arranged in parallel to each other for ease of description. Such a cut portion may be referred to as a plating crack.

For example, even if a part of the second electrode 22 is cut at the position 25 illustrated in (A) of FIG. 2, the second electrode 22 is in an electric connection state while the electrodes of the cut portion are in contact with each other. This connection state can also be referred to as pseudo contact. In this way, when the cut portion at the position 25 is in the electric connection state, both the capacitance and the resistance between the first electrode 21 and the second electrode 22 tend to have normal values.

However, in the steering wheel 10, when the cut portion is gripped by the hands of the driver through the exterior portion, a minute deformation occurs due to the load, and the cut portion is slightly separated. In this case, since a conduction resistance in the cut portion becomes large and a current hardly flows, a resistance of the cut portion in the second electrode 22 abnormally increases.

When a separation amount of the cut portion becomes too large, the cut portion is electrically completely disconnected, and thus an area of the second electrode 22 following the cut portion indicated by the position 25 is lost, and thus the capacitance also decreases in accordance with the reduction in the area. In (B) of FIG. 2, a range of the area of the second electrode 22 following the cut portion indicated by the position 25 is indicated by R1. When the cut portion of the second electrode 22 is electrically disconnected, a resistance value at the cut portion increases, but the capacitance decreases.

[Contact Determination Example as Comparative Example]

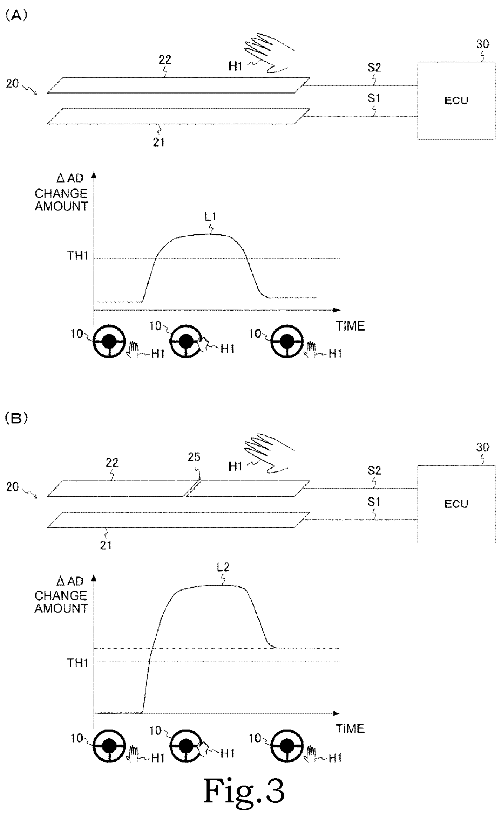

FIG. 3 is a diagram illustrating a contact determination example as a comparative example. Specifically, an example of a relationship between the capacitance generated in the electrode portion 20 and a determination value $\Delta$AD used when determining the contact of the driver with the steering wheel 10 is illustrated.

(A) of FIG. 3 illustrates an example of a case where the electrode portion 20 is in a normal state, that is, a case where there is no abnormality in the electrode portion 20, and (B) of FIG. 3 illustrates an example of a case where the electrode portion 20 is in a disconnection state, that is, a case where there is an abnormality in the electrode portion 20. (B) of FIG. 3 illustrates an example of a case where the position 25 is the cut portion, similar to the example illustrated in (B) of FIG. 2.

In the present embodiment, a state where the second electrode 22 is cut is referred to as an abnormal state, but the same can be applied to a case where the first electrode 21 is cut or a case where the abnormal state occurs for other reasons.

In the present embodiment, a case where the electrode portion 20 is abnormal will be described, but the present invention is not limited thereto, and the case where the electrode portion 20 is abnormal may be referred to as a case where the electrode portion 20 is failed, a case where the electrode portion 20 has a problem, or the like.

First, the determination value $\Delta$AD used in the comparative example will be described. The determination value $\Delta$AD can be obtained by the following Expression 1. Crg represents the capacitance generated between the hand of the driver and the second electrode 22 when the hand approaches the second electrode 22. Crs represents the capacitance between the first electrode 21 and the second electrode 22. That is, Crs means a capacitance originally held by the electrode portion 20. Instead of the determination value $\Delta$AD, a difference value of $\Delta$AD shown in Expression 1 may be used as the determination value.

$$\Delta AD = Crg/(Crs + Crg) \ldots \quad \text{Expression 1}$$

The capacitance Crs between the first electrode 21 and the second electrode 22 can be obtained by the following Expression 2. εrs represents a dielectric constant between the first electrode 21 and the second electrode 22. drs represents a distance between the first electrode 21 and the second electrode 22. Srs represents an area of the second electrode 22.

$$Crs = \varepsilon rs(Srs/drs) \ldots \quad \text{Expression 2}$$

In the electrode portion 20, a capacitance Crgl between the core metal 11 and the second electrode 22 and a capacitance Csg between the core metal 11 and the first electrode 21 are also generated, and descriptions thereof are omitted here.

The capacitance Crs between the first electrode 21 and the second electrode 22 is normally a fixed value. Regarding this, a value of the capacitance Crg changes according to a contact state of the driver on the steering wheel 10. Specifically, in a state where the hand of the driver is not in contact with the steering wheel 10, the value of the capacitance Crg is 0 or close to 0. On the other hand, in a state where the hand of the driver is in contact with the steering wheel 10, the value of the capacitance Crg increases according to the degree of contact. That is, when the driver grips the steering wheel 10, the capacitance Crg is added, and the determination value ΔAD increases. When the driver continues to grip the steering wheel 10, the determination value ΔAD is maintained at a high value. On the other hand, when the driver releases the steering wheel 10, the determination value ΔAD rapidly decreases.

In this comparative example, when the determination value ΔAD exceeds a contact threshold TH1, it is determined that there is the contact. For example, as illustrated by a curve L1 in a lower graph in (A) of FIG. 3, when the determination value ΔAD exceeds the contact threshold TH1, it is determined that there is the contact.

Here, the capacitances and the resistances between the first electrode 21 and the second electrode 22 in the case where the electrode portion 20 is in the normal state (see (A) of FIG. 3) and in a case where the electrode portion 20 is in the disconnection state (see (B) of FIG. 3) will be described.

Comparing the case where the electrode portion 20 is in the normal state (see (A) of FIG. 3) with the case where the electrode portion 20 is in the disconnection state (see (B) of FIG. 3), the area of the second electrode 22 following the cut portion indicated by the position 25 is lost in the case where the electrode portion 20 is in the disconnection state. Therefore, it is difficult for electricity to flow between the first electrode 21 and the second electrode 22, and a resistance value Rs2 between the first electrode 21 and the second electrode 22 in the case where the electrode portion 20 is in the disconnection state is larger than a resistance value Rs1 between the first electrode 21 and the second electrode 22 in the case where the electrode portion 20 is in the normal state.

Since the area of the second electrode 22 is lost, a capacitance Crs2 between the first electrode 21 and the second electrode 22 in the case where the electrode portion 20 is in the disconnection state is less than a capacitance Crs1 between the first electrode 21 and the second electrode 22 in the case where the electrode portion 20 is in the normal state.

As described above, when the area of the second electrode 22 decreases, the capacitance Crs2 between the first electrode 21 and the second electrode 22 decreases, and a denominator of Expression 1 becomes smaller and the value of the determination value ΔAD becomes larger. When the disconnection state of the electrode portion 20 continues after the driver releases his or her hand from the steering wheel 10, a state where the value of the determination value ΔAD is large continues, and the determination value ΔAD may exceed the contact threshold TH1. For example, as indicated by a curve L2 in a lower graph in (B) of FIG. 3, a state where the determination value ΔAD exceeds the contact threshold TH1 may be maintained even though the driver releases his or her hand from the steering wheel 10. In this case, the contact determination device 1 may make an erroneous determination. Therefore, in the present embodiment, an example in which the contact determination is performed using a decrease in a capacitance component and an increase in a resistance component in the case where the electrode portion 20 is in the disconnection state is illustrated. Accordingly, for example, a logic that does not determine that there is the contact when the capacitance component decreases and the resistance component increases apparently due to the cut of the electrode can be implemented.

[Contact Determination Example Based on Capacitance and Impedance]

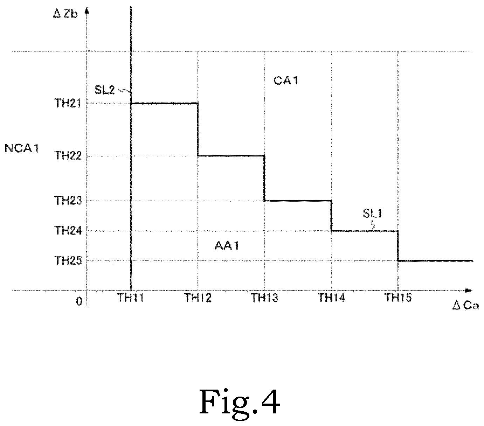

FIG. 4 is a diagram illustrating an example of determination processing for performing a contact determination based on a capacitance ΔCa and an impedance ΔZb generated in the electrode portion 20. A horizontal axis illustrated in FIG. 4 represents the capacitance ΔCa, and a vertical axis illustrated in FIG. 4 represents the impedance ΔZb. The impedance means a resistance when an alternating current flows, and is also referred to as an alternating current resistance.

The capacitance ΔCa illustrated in FIG. 4 means the capacitance generated in the second electrode 22 in response to the contact of the driver with the steering wheel 10. The impedance $\Delta Zb$ means the impedance between the first electrode 21 and the second electrode 22.

Here, in the case where the electrode portion 20 is in the normal state, when the driver grips the steering wheel 10, the capacitance Crg increases according to the contact state of the driver on the steering wheel 10. However, since the resistance between the first electrode 21 and the second electrode 22 is not changed by the contact of the driver, a variation of the impedance $\Delta Zb$ is small. Therefore, in the case where the electrode portion 20 is in the normal state, a slop ($\Delta Zb/\Delta Ca$) of the capacitance $\Delta Ca$ and the impedance $\Delta Zb$ is a low value, for example, about 1/8 to 1/15 even when the driver grips the steering wheel 10. That is, in the case where the electrode portion 20 is in the normal state, the slop ($\Delta Zb/\Delta Ca$) of the capacitance $\Delta Ca$ and the impedance $\Delta Zb$ is small even when the driver grips the steering wheel 10.

In contrast, in the case where the electrode portion 20 is in the abnormal state, for example, in a case where the second electrode 22 is in a cut state, when the driver grips the steering wheel 10, the capacitance Crg increases according to the contact state of the driver on the steering wheel 10. The resistance between the first electrode 21 and the second electrode 22 is changed by the contact of the driver as illustrated in FIGS. 2 and 3 in the case where the second electrode 22 is in the cut state due to the contact of the driver. That is, in the case where the second electrode 22 is in the cut state due to the contact of the driver, the resistance value changes to a small value according to the contact state of the driver. Therefore, the variation of the impedance $\Delta Zb$ becomes large. That is, since the impedance $\Delta Zb$ greatly decreases according to the contact state of the driver, the variation also increases.

Therefore, in the case where the electrode portion 20 is in the abnormal state, when the driver grips the steering wheel 10, an absolute value of the slop ($\Delta Zb/\Delta Ca$) of the capacitance $\Delta Ca$ and the impedance $\Delta Zb$ is a high value, for example, 1 to 2 or more. That is, in the case where the electrode portion 20 is in the abnormal state, when the driver grips the steering wheel 10, the slope ($\Delta Zb/\Delta Ca$) of the capacitance $\Delta Ca$ and the impedance $\Delta Zb$ increases. That is, a change amount of the impedance $\Delta Zb$ greatly varies with respect to a change amount of the capacitance $\Delta Ca$.

In the case where the second electrode 22 is in the cut state regardless of the presence or absence of the contact of the driver, the resistance between the first electrode 21 and the second electrode 22 does not change due to the contact of the driver, but the resistance value becomes small. Therefore, in the case where the second electrode 22 is in the cut state regardless of the presence or absence of the contact of the driver, the value of the impedance $\Delta Zb$ becomes small.

Therefore, in the present embodiment, the contact determination is performed using the relationship between the capacitance $\Delta Ca$ and the impedance $\Delta Zb$. Specifically, when the capacitance $\Delta Ca$ is equal to or less than a contact threshold TH11 indicated by a straight line SL2, it is determined that there is non-contact. That is, when an intersection point of the capacitance $\Delta Ca$ and the impedance $\Delta Zb$ is present in a non-contact region NCA1, it is determined that there is the non-contact.

On the other hand, when the capacitance $\Delta Ca$ exceeds the contact threshold TH11 indicated by the straight line SL2, it is determined that there is the contact. However, even when the capacitance $\Delta Ca$ exceeds the contact threshold TH11 (straight line SL2), when the impedance $\Delta Zb$ is equal to or less than a stepped polygonal line SL1, it is assumed that the electrode portion 20 is in the abnormal state, for example, the second electrode 22 is in the cut state, and thus it is determined that there is an abnormality. That is, when the intersection point of the capacitance $\Delta Ca$ and the impedance $\Delta Zb$ is present in a contact region CA1, it is determined that there is the contact, and when the intersection point of the capacitance $\Delta Ca$ and the impedance $\Delta Zb$ is present in an abnormal region AA1, it is determined that there is an abnormality.

Here, the contact threshold TH11 is a contact determination threshold used when determining the contact of the driver with the steering wheel 10. The contact threshold TH11 can be appropriately set based on experiment data or the like. The contact threshold TH11 may be a fixed value, or may be variable depending on the driver, an internal environment of the vehicle, and a surrounding environment of the vehicle, such as a temperature and humidity.

The stepped polygonal line SL1 represents an abnormality determination threshold used when determining the abnormality in the electrode portion 20. For example, when the capacitance $\Delta Ca$ is in a range larger than the contact threshold TH11 and equal to or less than TH12, the abnormality determination threshold is set to TH21. when the capacitance $\Delta Ca$ is in a range larger than TH12 and equal to or less than TH13, the abnormality determination threshold is set to TH22. Thereafter, TH23 to TH25 are set as the abnormality determination thresholds according to ranges (TH13 to TH15) of the capacitance $\Delta Ca$ in the same manner. In this way, the values TH21 to TH25 that decrease with an increase in the capacitance $\Delta Ca$ can be set as the abnormality determination thresholds.

Although FIG. 4 illustrates an example in which the abnormality determination thresholds TH21 to TH25 that decrease stepwise are set, another threshold that decreases in accordance with an increase in the capacitance $\Delta Ca$ may be set as the abnormality determination threshold. For example, a value TH shown in the following Expression 3 can be set as the abnormality determination threshold. DC1 and $\alpha1$ represent diagnostic coefficients, and can be appropriately set based on experiment data or the like.

$$TH = \Delta Ca \times DC1 + \alpha1 \ldots \quad \text{Expression 3}$$

That is, when the capacitance ΔCa is larger than the contact threshold TH11 and the impedance ΔZb satisfies the following Expression 4, it is determined that there is the contact. On the other hand, when the capacitance ΔCa is larger than the contact threshold TH11 but the impedance ΔZb does not satisfy the following Expression 4, it is determined that there is an abnormality.

$$\Delta Zb > \Delta Ca \times DC1 + \alpha 1 \ ... \quad \text{Expression 4}$$

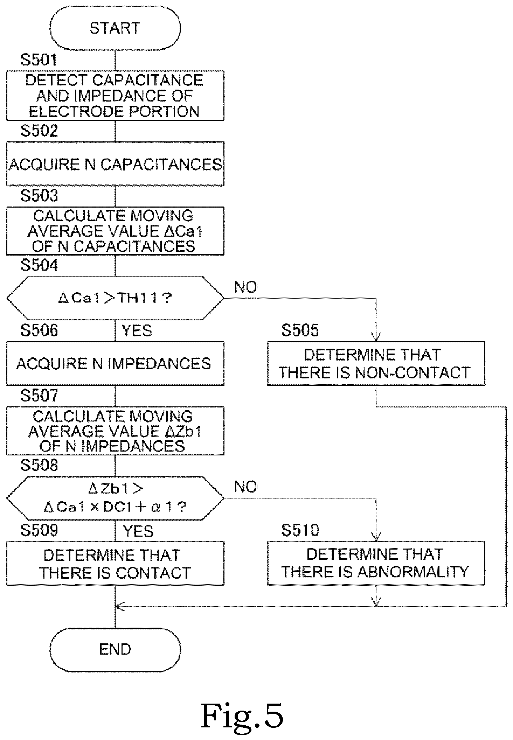

In FIG. 4, for ease of description, an example in which the contact determination is performed using the relationship between the latest capacitance ΔCa and the latest impedance ΔZb is illustrated. However, since it is assumed that an abnormal value may be detected due to variation, radio noise, or the like, it is preferable to use detection results of a plurality of detections in order to eliminate such an abnormal value and improve reliability. This example is illustrated in FIG. 5.

[Operation Example of Contact Determination Device]

FIG. 5 is a flowchart illustrating an example of contact determination processing in the contact determination device 1. The contact determination processing is executed by the ECU 30 based on a program stored in the storage unit (not illustrated). The contact determination processing is always executed in each control cycle. The determination unit 32 holds the capacitance and the impedance detected by the detection unit 31 a predetermined number of times. The predetermined number of times is a value equal to or larger than N. Here, N represents a value appropriately set based on experiment data or the like.

In step S501, the detection unit 31 detects the capacitance ΔCa and the impedance ΔZb of the electrode portion 20.

In step S502, the determination unit 32 acquires N capacitances among the capacitances detected by the detection unit 31. Here, the N capacitances are N values from the capacitance acquired last to the capacitance acquired N times before.

In step S503, the determination unit 32 calculates a moving average value ΔCa1 of the N capacitances acquired in step S501. Here, the moving average value ΔCa1 means an average value of the N capacitances. Although FIG. 5 illustrates an example in which the moving average value ΔCa1 is used, as described above, a single capacitance may be used, or other values calculated by using one or more capacitances may be used.

In step S504, the determination unit 32 determines whether the moving average value ΔCa1 calculated in step S503 is larger than the contact threshold TH11 (see FIG. 4). when the moving average value ΔCa1 is equal to or less than the contact threshold TH11, the processing proceeds to step S505. On the other hand, when the moving average value ΔCa1 is larger than the contact threshold TH11, the processing proceeds to step S506.

In step S505, the determination unit 32 determines that the hand of the driver is not in contact with the steering wheel 10. That is, since the moving average value ΔCa1 is present in the non-contact region NCA1 (see FIG. 4), it is determined that there is the non-contact.

In step S506, the determination unit 32 acquires N impedances among the impedances detected by the detection unit 31. Here, the N impedances are N values from the last acquired impedance to the impedances acquired N times before.

In step S507, the determination unit 32 calculates a moving average value ΔZb1 of the N impedances acquired in step S505. Here, the moving average value ΔZb1 means an average value of the N impedances. Although FIG. 5 illustrates an example in which the moving average value ΔZb1 is used, as described above, a single impedance may be used, or other values calculated by using one or more impedances may be used.

In step S508, the determination unit 32 determines whether the moving average value ΔZb1 calculated in step S507 satisfies Expression 4 described above. when the moving average value ΔZb1 satisfies Expression 4 described above, the processing proceeds to step S509. On the other hand, when the moving average value ΔZb1 does not satisfy Expression 4 described above, the processing proceeds to step S510.

In step S509, the determination unit 32 determines that the hand of the driver is in contact with the steering wheel 10. That is, since an intersection point of the moving average value ΔZb1 and the moving average value ΔCa1 is present in the contact region CA1 (see FIG. 4), it is determined that there is the contact.

In step S510, the determination unit 32 determines that the contact determination device 1 is abnormal. That is, since the intersection point of the moving average value ΔZb1 and the moving average value ΔCa1 is present in the abnormal region AA1 (see FIG. 4), it is determined that there is an abnormality.

The determination unit 32 outputs a determination result to be used for autonomous driving or outputting an alarm. For example, when it is determined that the driver drives the vehicle with his or her hand released at a predetermined autonomous driving level, an alarm is output. For example, an alarm may be output when it is determined that an abnormality is present in the electrode portion 20.

FIG. 5 illustrates an example in which it is determined that the electrode portion 20 is abnormal even when the number of times that the moving average value $\Delta$Cal exceeds the contact threshold TH11 and the moving average value $\Delta$Zb1 becomes equal to or less than the abnormality determination threshold (abnormality determination threshold TH shown in Expression 3 is one. However, it may be determined that the electrode portion 20 is abnormal when the number of times that the moving average value $\Delta$Ca1 exceeds the contact threshold TH11 and the moving average value $\Delta$Zb1 becomes equal to or less than the abnormality determination threshold (abnormality determination threshold TH shown in Expression 3) is equal to or larger than a predetermined number (2 or more). Accordingly, even if an abnormal value is detected due to variation, radio noise, or the like, the abnormal value can be eliminated, thereby improving a determination accuracy of the contact determination.

In this way, in the present embodiment, when the contact of the driver with the steering wheel 10 is determined, the abnormal state of the electrode portion 20 can be more reliably determined using the capacitance $\Delta$Ca and the impedance $\Delta$Zb of the electrode portion 20. Accordingly, for example, it is possible to prevent an appropriate contact determination from not being performed due to an electrode failure. By only changing the logic of the software, the determination accuracy of the contact determination can be improved, and robustness can be improved.

[Configuration and Effects of Present Embodiment]

A contact determination method according to the present embodiment is a contact determination method for determining contact of a driver with the steering wheel 10 based on the electric signal detected from the sheet-shaped electrode portion 20, the electrode portion 20 formed by laminating the first electrode 21 and the second electrode 22 with the insulator 23 interposed therebetween and being provided to cover the outer peripheral portion of the steering wheel 10. The contact determination method includes a detection step (step S501) of detecting the capacitance $\Delta$Ca and the impedance $\Delta$Zb generated in the electrode portion 20, and a determination step (steps S502 to S510) of determining, based on the capacitance $\Delta$Ca and the impedance $\Delta$Zb detected in the detection step, whether the hand of the driver is in contact with the steering wheel 10 and whether the electrode portion 20 is abnormal. In the determination step (steps S504, S508, and S510), when the capacitance $\Delta$Ca exceeds the contact threshold TH11 (example of first threshold) and the impedance $\Delta$Zb is less than the abnormality determination threshold (polygonal line SL1 (see FIG. 4), abnormality determination threshold TH shown in Expression 3 (example of second threshold)), it is determined that the electrode portion 20 is abnormal.

According to this configuration, when the contact of the driver with the steering wheel 10 is determined, the abnormal state of the electrode portion 20 can be more reliably determined using the capacitance $\Delta$Ca and the impedance $\Delta$Zb of the electrode portion 20.

In the contact determination method according to the present embodiment, a fixed value is set as the contact threshold TH11 (example of first threshold), and a variable value that decreases in accordance with an increase in the capacitance is set as the abnormality determination threshold (polygonal line SL1 (see FIG. 4), and abnormality determination threshold TH shown in Expression 3 (example of second threshold)).

According to this configuration, it is possible to more reliably determine the abnormal state of the electrode portion 20 by setting an appropriate threshold.

In the contact determination method according to the present embodiment, the abnormality determination threshold TH shown in Expression 3 (example of second threshold) is a value ($\Delta$Ca $\times$ DC1 + $\alpha$1) calculated based on the capacitance $\Delta$Ca and the predetermined coefficients (DC1, $\alpha$1).

According to this configuration, it is possible to more reliably determine the abnormal state of the electrode portion 20 by setting the threshold using the specific parameter.

In the contact determination method according to the present embodiment, in the determination step (steps S504, S508, and S510), the electrode portion 20 is determined to be abnormal when the number of times that the moving average value $\Delta$Ca1 of the predetermined number of the capacitances detected within a predetermined time exceeds the contact threshold TH11 (example of first threshold) and the moving average value $\Delta$Zb1 of the predetermined number of the impedances detected within the predetermined time is less than the abnormality determination threshold (polygonal line SL1 (see FIG. 4), abnormality determination threshold TH shown in Expression 3 (example of second threshold)) is equal to or larger than a predetermined number.

According to this configuration, even if an abnormal value is detected due to variation, radio noise, or the like, the abnormal value can be eliminated, thereby improving a determination accuracy of the abnormal state.

In the contact determination method according to the present embodiment, in the determination step, in steps S504 and S505, it is determined that the hand of the driver is not in contact with the steering wheel 10 when the moving average value $\Delta$Cal of the predetermined number of the capacitances detected within the predetermined time is equal to or less than the contact threshold TH11 (example of first threshold). In steps S504, S508, and S509, it is determined that the hand of the driver is in contact with the steering wheel 10 when the moving average value $\Delta$Cal of the capacitances is larger than the contact threshold TH11 and the moving average value $\Delta Zb1$ of the predetermined number of the impedances detected within the predetermined time is larger than the abnormality determination threshold (polygonal line SL1 (see FIG. 4), abnormality determination threshold TH shown in Expression 3 (example of second threshold)). In steps S504, S508, and S510, it is determined that the electrode portion 20 is abnormal when the moving average value $\Delta Ca1$ of the capacitances is larger than the contact threshold TH11 and the moving average value $\Delta Zb1$ of the impedances is equal to or smaller than the abnormality determination threshold.

According to this configuration, it is possible to more reliably determine the contact with the steering wheel 10 and the abnormal state of the electrode portion 20 by using a specific control logic.

In the contact determination method according to the present embodiment, the electrode portion 20 is configured such that the second electrode 22 is disposed outside the steering wheel 10 and the first electrode 21 is disposed inside the steering wheel 10. In the detection step (step S501), the capacitance $\Delta Ca$ generated in the second electrode 22 and the impedance $\Delta Zb$ generated between the first electrode 21 and the second electrode 22 are detected based on a difference between the alternating current signal input to the electrode portion 20 and the response signal acquired in response to the alternating current signal.

According to this configuration, it is possible to more reliably determine the abnormal state of the electrode portion 20 by detecting the appropriate capacitance $\Delta Ca$ and impedance $\Delta Zb$.

The contact determination device 1 is a contact determination device that determines contact of a driver with the steering wheel 10 based on the electric signal detected from the sheet-shaped electrode portion 20, the electrode portion 20 formed by laminating the first electrode 21 and the second electrode 22 with the insulator 23 interposed therebetween and being provided to cover the outer peripheral portion of the steering wheel 10. The contact determination device 1 includes the detection unit 31 configured to detect the capacitance $\Delta Ca$ and the impedance $\Delta Zb$ generated in the electrode portion 20, and the determination unit 32 configured to determine, based on the capacitance $\Delta Ca$ and the impedance $\Delta Zb$ detected by the detection unit 31, whether the hand of the driver is in contact with the steering wheel 10 and whether the electrode portion 20 is abnormal. When the capacitance $\Delta Ca$ exceeds the contact threshold TH11 (example of first threshold) and the impedance $\Delta Zb$ is less than the abnormality determination threshold (polygonal line SL1 (see FIG. 4), abnormality determination threshold TH shown in Expression 3 (example of second threshold)), the determination unit 32 determines that the electrode portion 20 is abnormal.

According to this configuration, when the contact of the driver with the steering wheel 10 is determined, the abnormal state of the electrode portion 20 can be more reliably determined using the capacitance $\Delta Ca$ and the impedance $\Delta Zb$ of the electrode portion 20.

Each processing procedure described in the present embodiment is an example for implementing the present embodiment, and an order of a part of each processing procedure may be changed within the scope of implementing the present embodiment, or a part of each processing procedure may be omitted or other processing procedures may be added.

It should be noted that the processing described in the present embodiment is executed based on a program for causing a computer to execute each processing procedure. Therefore, the present embodiment can be understood as an embodiment of a program that implements a function of executing the processing and a recording medium that stores the program. For example, the program can be stored in a storage device of the contact determination device by performing update processing for adding a new function to the contact determination device. Accordingly, it is possible to cause the updated contact determination device to perform the processing described in the present embodiment.

Although the embodiment of the present invention has been described above, the above embodiment is merely a part of application examples of the present invention, and does not mean that the technical scope of the present invention is limited to the specific configurations of the above embodiment.

**Claims**

1. A contact determination method for determining contact of a driver with a steering wheel based on an electric signal detected from a sheet-shaped electrode portion, the electrode portion being formed by laminating a first electrode and a second electrode with an insulator interposed between and being provided to cover an outer peripheral portion of the steering wheel, the contact determination method comprising:

   a detection step of detecting a capacitance and an impedance generated in the electrode portion; and
   a determination step of determining, based on the capacitance and the impedance detected in the detection step, whether a hand of a driver is in contact with the steering wheel and whether the electrode portion is abnormal, wherein
   in the determination step, the electrode portion is determined to be abnormal when the capacitance exceeds a first threshold and the impedance is less than a second threshold.

2. The contact determination method according to claim 1, wherein
a fixed value is set as the first threshold, and a variable value that decreases as the capacitance increases is set as the second threshold.

3. The contact determination method according to claim 1 or 2, wherein
the second threshold is a value calculated based on the capacitance and a predetermined coefficient.

4. The contact determination method according to any one of claims 1 to 3, wherein
in the determination step, the electrode portion is determined to be abnormal when the number of times that a moving average value of a predetermined number of the capacitances detected within a predetermined time exceeds the first threshold and a moving average value of a predetermined number of the impedances detected within the predetermined time is less than the second threshold is equal to or larger than a predetermined number.

5. The contact determination method according to any one of claims 1 to 3, wherein
in the determination step, it is determined that a hand of a driver is not in contact with the steering wheel when a moving average value of a predetermined number of the capacitances detected within a predetermined time is equal to or less than the first threshold, it is determined that a hand of a driver is in contact with the steering wheel when the moving average value of the capacitances is larger than the first threshold and a moving average value of a predetermined number of the impedances detected within the predetermined time is larger than the second threshold, and it is determined that the electrode portion is abnormal when the moving average value of the capacitances is larger than the first threshold and the moving average value of the impedances is equal to or less than the second threshold.

6. The contact determination method according to any one of claims 1 to 5, wherein

the electrode portion is configured such that the second electrode is disposed outside the steering wheel and the first electrode is disposed inside the steering wheel, and
in the detection step, the capacitance generated in the second electrode and the impedance generated between the first electrode and the second electrode are detected based on a difference between an alternating current signal input to the electrode portion and a response signal acquired in response to the alternating current signal.

7. A contact determination device that determines contact of a driver with a steering wheel based on an electric signal detected from a sheet-shaped electrode portion, the electrode portion being formed by laminating a first electrode and a second electrode with an insulator interposed between and being provided to cover an outer peripheral portion of the steering wheel, the contact determination device comprising:

a detection unit configured to detect a capacitance and an impedance generated in the electrode portion; and
a determination unit configured to determine, based on the capacitance and the impedance detected by the detection unit, whether a hand of a driver is in contact with the steering wheel and whether the electrode portion is abnormal, wherein
the determination unit determines that the electrode portion is abnormal when the capacitance exceeds a first threshold and the impedance is less than a second threshold.

Fig.1

(A)

(B)

Fig.2

(A)

(B)

Fig.3

Fig.4

Fig.5

<table>
<tr><td colspan="2"><b>INTERNATIONAL SEARCH REPORT</b></td><td colspan="2">International application No.<br><b>PCT/JP2022/017065</b></td></tr>
</table>

**A.    CLASSIFICATION OF SUBJECT MATTER**

**B62D 1/06**(2006.01)i
FI:    B62D1/06

According to International Patent Classification (IPC) or to both national classification and IPC

**B.    FIELDS SEARCHED**

Minimum documentation searched (classification system followed by classification symbols)

B62D1/04

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| A | JP 2019-23011 A (HONDA MOTOR CO., LTD.) 14 February 2019 (2019-02-14) paragraphs [0006]-[0009], [0047]-[0049], fig. 1-4, 6 | 1-7 |
| A | JP 2021-127059 A (HONDA MOTOR CO., LTD.) 02 September 2021 (2021-09-02) paragraphs [0009], [0039]-[0048], fig. 1-5 | 1-7 |
| A | US 2021/0270637 A1 (AUTOLIV DEVELOPMENT AB) 02 September 2021 (2021-09-02) paragraphs [0049], [0050], fig. 1, 2 | 1-7 |

☐ Further documents are listed in the continuation of Box C.          ☑ See patent family annex.

| | | |
|---|---|---|
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" document member of the same patent family |
| "P" | document published prior to the international filing date but later than the priority date claimed | |

| Date of the actual completion of the international search | Date of mailing of the international search report |
|---|---|
| **26 April 2022** | **17 May 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2022/017065**

| Patent document cited in search report | | | Publication date (day/month/year) | Patent family member(s) | | | Publication date (day/month/year) |
|---|---|---|---|---|---|---|---|
| JP | 2019-23011 | A | 14 February 2019 | US | 2019/0023310 | A1 | |
| | | | | paragraphs [0006]-[0013], [0058]-[0060], fig. 1-4, 6 | | | |
| | | | | CN | 109291928 | A | |
| JP | 2021-127059 | A | 02 September 2021 | (Family: none) | | | |
| US | 2021/0270637 | A1 | 02 September 2021 | WO | 2020/002079 | A1 | |
| | | | | FR | 3065294 | A1 | |
| | | | | CN | 112166065 | A | |

Form PCT/ISA/210 (patent family annex) (January 2015)

**EP 4 506 231 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2021095478 A